# EUROPÄISCHE PATENTSCHRIFT

(11) **EP 0 853 819 B1**
(45) Veröffentlichungstag und Bekanntmachung des Hinweises auf die Patenterteilung: **02.02.2000**
(21) Anmeldenummer: 96934486.0
(22) Anmeldetag: 28.09.1996
(51) Int. Cl.: H01L 29/78, H01L 21/336

(54) **MOS-TRANSISTOR MIT HOHER AUSGANGSSPANNUNGSFESTIGKEIT**
MOS TRANSISTOR WITH HIGH OUTPUT VOLTAGE ENDURANCE
TRANSISTOR MOS A HAUTE RIGIDITE DIELECTRIQUE DE SORTIE

(30) Priorität: 02.10.1995 DE 19536753
(43) Veröffentlichungstag der Anmeldung: 22.07.1998
(73) Patentinhaber: ELMOS Semiconductor AG, 44227 Dortmund (DE)
(72) Erfinder: ROTH, Walter, D-44149 Dortmund (DE); GIEBEL, Thomas, D-44139 Dortmund (DE)
(74) Vertreter: Hilleringmann, Jochen, Dipl.-Ing.
(86) Internationale Anmeldenummer: EP9604246
(87) Internationale Veröffentlichungsnummer: WO9713277

(56) Entgegenhaltungen:
- EP-A- 0 110 320
- EP-A- 0 386 779
- EP-A- 0 400 934
- EP-A- 0 637 846
- EP-A- 0 660 419
- DE-A- 3 816 002
- DE-A- 4 336 054
- PATENT ABSTRACTS OF JAPAN vol. 007, no. 255 (E-210), 12.November 1983 & JP 58 140165 A (ROOMU KK), 19.August 1983,

## Beschreibung

Die Erfindung betrifft einen MOS-Transistor mit hoher Ausgangsspannungsfestigkeit, wie aus EP-A-0 637 846 bekannt.

Bei einer Vielzahl von Applikationen ist es wünschenswert, daß MOS-Transistoren am Ausgang auch bei hohen Ausgangsspannungen zwischen 180 V bis 200 V nicht zerstört werden. Derartig hohe Ausgangsspannungen können durch externe Einflüsse auf eine Schaltung kurzzeitig anstehen. Derartig hohe Spitzenspannungen treten insbesondere bei elektronischen Schaltungen für Kraftfahrzeuge auf. Der in Bezug auf einen (irreversiblen) Durchbruch sensibelste Bereich eines MOS-Transistors ist die drainseitige Gate-Kante, da infolge des Kanteneffekts dort recht hohe elektrische Felder auftreten. Zur Erzielung eines geringen Einschaltwiderstandes ist es nämlich wünschenswert, daß der Bereich zwischen der drainseitigen Gate-Kante und dem Drain-Anschluß selbst elektrisch gut leitend ist. Das bedeutet aber, daß nahezu die gesamte Ausgangsspannung (im Ausschaltzustand des Transistors im Bereich der drainseitigen Gate-Kante abfällt. Da die Gate-Oxidschicht nur eine sehr geringe Dicke aufweisen darf, sind MOS-Transistoren ohne besondere Maßnahmen nur wenig ausgangsspannungsfest.

In EP-A-0 449 858 ist ein NMOS-Transistor mit erhöhter Ausgangsspannungsfestigkeit beschrieben. Bei diesem Transistor ist um das (entartet dotierte) Drain-Anschlußgebiet eine weniger stark dotierte Wanne vom gleichen Leitungstyp wie das Drain-Anschlußgebiet (im Falle eines NMOS-Transistors handelt es sich bei diesem Leitungstyp um den n-Leitungstyp) gelegt. Diese schwächer dotierte n-Wanne reicht bis unterhalb der drainseitigen Kante der Gate-Oxidschicht. Die n-Wanne wird durch Ionenimplantation und anschließende Ausdiffusion hergestellt. Wegen der im Vergleich zum Drain-Anschlußgebiet geringeren Dotierung stellt sich damit zwischen dem Drain-Anschlußgebiet und der drainseitigen Kante der Gate-Oxidschicht ein Dotierungsbereich mit in lateraler Erstreckung verringerter Oberflächenkonzentration ein. In diesem schwächer dotierten n-Wannengebiet, der in einem p-Substrat ausgebildet ist, kann sich dann eine Raumladungszone ausreichend weit ausbilden, so daß der NMOS-Transistor auch bei höheren Ausgangsspannungen noch durchbruchfest ist. Mit der in EP-A-0 449 858 beschriebenen Maßnahme läßt sich die Ausgangsspannungsfestigkeit eines MOS-Transistors jedoch nicht beliebig erhöhen, so daß dieser Vorgehensweise Grenzen gesetzt sind.

Aus EP-A-0 637 846 ist ein MOS-Transistor nach dem Oberbegriff des Anspruchs 1 bekannt. Dieser Transistor weist eine gradierte Drift-Zone zwischen der drainseitigen Gate-Kante und dem Drain auf, die aus mehreren diffundierten Teilgebieten besteht. Weitere Transistoren mit bezüglich ihrer Dotierung gradierten Bereichen zwischen Gate und Drain sind aus EP-A-0 400 934 und EP-A-0 669 419 bekannt. Aus EP-A- 0 386 779 schließlich ist eine MOS-Transistor-Stuktur mit einer konzentrisch um den Drain-Bereich aufgebauten Anordnung von eindiffundierten Bereichen bekannt.

Der Erfindung liegt die Aufgabe zugrunde, einen MOS-Transistor zu schaffen, der über eine verbesserte Ausgangsspannungsfestigkeit verfügt und insbesondere auch bei Ausgangsspannungen von 160 V bis 180 V im gesperrten Zustand durchbruchsicher ist.

Zur Lösung dieser Aufgabe wird mit der Erfindung ein MOS-Transistor mit den Merkmalen des Anspruchs 1 vorgeschlagen; vorteilhafte Weiterbildungen der Erfindung ergeben sich aus den Unteransprüchen.

Der erfindungsgemäße MOS-Transistor läßt sich sowohl als PMOS- als auch als NMOS-Transistor ausführen. Die Erfindung wird nachfolgend anhand eines NMOS-Transistors erläutert.

Bei dem erfindungsgemäßen Transistor sind in einem schwach p-dotierten Halbleiter-Substrat zwei Anschlußgebiete für Drain und Source eingebracht. Diese Anschlußgebiete befinden sich in der Oberfläche des Substrats und sind sehr hoch bis entartet n-dotiert (Dotierungskonzentration größer als 10¹⁷ Atome pro cm³). Zwischen die beiden Anschlußgebiete ist auf der Oberfläche eine Gate-Oxidschicht aufgebracht, die an das Source-Anschlußgebiet angrenzend angeordnet ist und vom Drain-Anschlußgebiet beabstandet ist. Während also die sourceseitige Kante der Gate-Oxidschicht mit der Begrenzung des Source-Anschlußgebiets fluchtet bzw. dieses geringfügig überlappt, ist die drainseitige Kante der Gate-Oxidschicht vom Drain-Anschlußgebiet beabstandet. In der Oberfläche des Substrats zwischen dem Drain-Anschlußgebiet und der drainseitigen Kante der Gate-Oxidschicht ist ein Dotierungsgebiet ausgebildet, das sich bis unterhalb der Gate-Oxidschicht erstreckt. Dieses Gebiet ist n-dotiert, wobei die Oberflächenkonzentration moduliert ist. Die Modulation ist dabei derart gewählt, daß die Oberflächenkonzentration innerhalb des Dotierungsgebiets ausgehend vom Drain-Anschlußgebiet bis zum sourceseitigen, unterhalb der Gate-Oxidschicht angeordneten Bereich insgesamt abnimmt. Die Abnahme der Oberflächenkonzentration wird dabei durch Ionenimplantation mehrerer zwischen dem Drain-Anschlußgebiet und der drainseitigen Kante der Gate-Oxidschicht angeordneter Teilgebiete mit anschließender Ausdiffusion dieser ionenimplantierten Teilgebiete erzielt.

Nach der Erfindung ist ferner vorgesehen, daß die Teilgebiete Ringstruktur aufweisen. Dabei umschließt das erste Teilgebiet das Drain-Anschlußgebiet und kontaktiert dieses. Das oder die zweiten Teilgebiete sind dann als Ringe um das erste Teilgebiet herum ausgebildet, wobei diese Ringe insbesondere konzentrisch sind.

Die ionenimplantierten Teilgebiete, die nach ihrer Ausdiffusion das Dotierungsgebiet mit zum Gate hin abnehmendem Oberflächen-Dotierungskonzentrationsprofil bilden, umfassen ein erstes Teilgebiet, dessen Abmessung in Drain-Gate-Erstreckung wesentlich größer ist als die Eindringtiefe der Ausdiffusion in das Substrat. Dieses erste Teilgebiet ist schwächer dotiert als das Drain-Anschlußgebiet. Zusätzlich zum ersten Teilgebiet ist mindestens ein zweites Teilgebiet vorgesehen, das in Drain-Gate-Erstreckung eine geringere Abmessung als das erste Teilgebiet aufweist. Der Abstand dieses mindestens einen zweiten Teilgebiets zum ersten Teilgebiet ist kleiner als die Eindringtiefe der Ausdiffusion in das Substrat. Ebenso gilt, daß die Abmessung des zweiten Teilgebiets in Drain-Gate-Erstreckung kleiner ist als die Eindringtiefe der Ausdiffusion in das Substrat. Diese Wahl der Abmessung des zweiten Teilgebiets sowie sein Abstand zum ersten Teilgebiet führen dazu, daß bei gleich starker Ionenimplantation dieser beiden Teilgebiete die lateralen Ausdiffusionen ineinanderlaufen. Anders ausgedrückt hängen die nach der Ionenimplantation noch getrennten Teilgebiete nach erfolgter Ausdiffusion zusammen. Hierdurch ergibt sich eine abnehmende Oberflächenkonzentration des Dotierstoffs im Dotierungsgebiet zur drainseitigen Gate-Kante hin. Infolge der zum Gate hin abnehmenden Oberflächenkonzentration bildet sich bei gesperrtem Transistor die Raumladungszone zwischen dem Substrat und dem Dotierungsgebiet zunehmend im Dotierungsgebiet aus. Außerdem kann sich eine räumlich vergrößerte Raumladungszone ausbilden, was dazu führt, daß in lateraler Richtung ein vergrößertes Gebiet für den Spannungsabbau zur Verfügung steht. Das wiederum bedeutet, daß der über der Gate-Oxidschicht fallende Anteil der Ausgangsspannung herabgesetzt ist oder, umgekehrt ausgedrückt, daß bei betragsmäßig gleichem Spannungsabfall über der Gate-Oxidschicht insgesamt zwischen Gate und Drain eine größere Ausgangsspannungsfestigkeit erzielbar ist. Wegen der infolge der abnehmenden Dotierung zum Drain hin verschobenen Raumladungszone kann der MOS-Transistor mit einem kürzeren Kanal, dessen Mindestlänge durch den Punch-Through-Effekt bestimmt ist, ausgestattet sein. Insgesamt benötigt der erfindungsgemäße MOS-Transistor nur wenig mehr Platz als ein herkömmlicher MOS-Transistor.

Um die (Rest-)Feldstärke an der drainseitigen Kante der Gate-Oxidschicht weiter abzubauen, ist erfindungsgemäß ferner vorgesehen, unterhalb dieser drainseitigen Kante eine intrinsische Zone in der Oberfläche des Substrats auszubilden. Innerhalb der intrinsischen Zone liegt quasi eine Null-Dotierstoffkonzentration vor, was zur Entschärfung der Feldspitze an der drainseitigen Kante der Gate-Oxidschicht beiträgt. Vorzugsweise wird diese intrinsische Zone ebenfalls als Ring innerhalb des Dotierungsgebiets ausgebildet.

Die intrinsische Zone wird durch eine "Gegendotierung" erzielt. Mittels dieser Gegendotierung lässt sich die elektrisch aktive Dotierung des Dotierungsgebiets an der Oberfläche gezielt bis auf Null verringern. Diese Gegendotierung kann zusammen mit dem bei einem MOS-Herstellungsprozeß üblichen Verfahrensschritt der Schwellenspannungs-Implantation realisiert werden. Der MOS-Prozeß selbst muß also für die Gegendotierung nicht verändert werden, was technologisch von Vorteil ist.

Durch die erfindungsgemäß vorgesehene Ionenimplantation einzelner voneinander beabstandeter Teilgebiete, von denen mit Ausnahme des dem Drain-Anschlußgebiet zugewandten Teilgebiets sämtliche anderen Teilgebiete Abmessungen in Drain-Gate-Erstreckung und Abstände zu benachbarten Teilgebieten aufweisen, die kleiner, insbesondere wesentlich kleiner sind als die Eindringtiefe der Ausdiffusion in das Substrat, wird in lateraler Richtung zwischen dem Drain-Anschlußgebiet und dem Gate bis unterhalb von dessen drainseitiger Kante eine stufenweise abnehmende Oberflächen-Dotierstoffkonzentration erzielt. Dieses Stufenprofil ist eine in der Praxis brauchbare Annäherung an das ideale geradlinig abnehmende Oberflächen-Konzentrationsprofil und hat technologisch den entscheidenden Vorteil, daß mit den bei einem CMOS-Prozeß üblichen Verfahrensschritten (Ionenimplantation und Ausdiffusion einer Wanne) gearbeitet werden kann. Die Abnahme der Oberflächenkonzentration wird nach der Erfindung durch die Größe, die Anzahl und den Abstand der zweiten Teilgebiete des Dotierungsgebiets erzielt. Dies ist letztendlich eine Frage der Ausmaskierung der Substratoberfläche bei der Ionenimplantation und ist deshalb recht einfach und wiederholbar durchzuführen.

Wie bereits oben erwähnt, setzt sich das Dotierungsgebiet aus einem ersten und mindestens einem zweiten ionenimplantierten und anschließend ausdiffundierten Teilgebiet zusammen. Im Falle mehrerer zweiter Teilgebiete sind diese untereinander beabstandet in Drain-Gate-Erstreckung zwischen dem ersten Teilgebiet und dem Gate aufeinanderfolgend angeordnet. Vorteilhafterweise weisen die zweiten Teilgebiete mit zunehmender Entfernung vom ersten Teilgebiet kleinere Abmessungen in ihren Drain-Gate-Erstreckungen auf. Mit anderen Worten werden also die zweiten Teilgebiete umso schmaler (in Drain-Gate-Erstreckung betrachtet) je näher sie am Gate liegen. Dadurch läßt sich in Stufen eine immer weiter reduzierte Oberflächenkonzentration zur drainseitigen Kante der Gate-Oxidschicht erzielen.

Zweckmäßigerweise sind im Falle mehrerer zweiter Teilgebiete deren Abstände untereinander sowie der Abstand des ersten Teilgebiets zum diesem am nächsten liegenden zweiten Teilgebiet im wesentlichen gleich. Alternativ kann vorgesehen sein, daß im Falle mehrerer zweiter Teilgebiete deren Abstände untereinander mit zunehmender Entfernung der zweiten Teilgebiete vom ersten Teilgebiet sich vergrößern. Durch die Wahl der Weite und insbesondere durch die Veränderung des Abstandes der Teilgebiete ergeben sich weitere Möglichkeiten der Dotierstoffkonzentrationsabnahme an der Oberfläche des Substrats zum Gate hin. Vorzugsweise weist das am weitesten von dem Drain-Anschlußgebiet angeordnete Teilgebiet eine Vielzahl von insbesondere punktförmigen Gebieten auf. Damit ergibt sich die Möglichkeit, die Dotierstoffkonzentration dreidimensional beeinflussen zu können.

Bei der Herstellung des erfindungsgemäßen MOS-Transistors wird, was das Dotierungsgebiet und das Drain-Anschlußgebiet betrifft, derartig verfahren, daß zunächst die Teilgebiete ionenimplantiert werden, um anschließend auszudiffundieren. Danach wird durch Ionenimplantation innerhalb des ersten Teilgebiets der entartet dotierte Drain-Anschlußbereich erzeugt.

Damit sich bei gesperrtem Transistor die Raumladungszone in Richtung auf das Source-Anschlußgebiet weiter ausdehnen kann, ist es zweckmäßig, die Schwellenspannungs-Implantation des Transistors auf das unbedingt nötige Maß angrenzend an das Source-Anschlußgebiet zu beschränken bzw. bei einem symmetrischen Transistor lediglich die Kanalmitte zu implantieren. Ein symmetrischer Transistor weist das oben beschriebene bzgl. des Dotierstoffkonzentrationsgradienten an der Oberfläche gezielt eingestellte Dotierungsgebiet sowohl um sein Source- als auch Drain-Anschlußgebiet auf. Bei einem symmetrischen Transistor ist es möglich, sowohl an Drain als auch an Source hohe Spannung anzulegen.

Der erfindungsgemäße MOS-Transistor läßt sich vorteilhaft auch mit einer an die dünne Gate-Oxidschicht angrenzenden dickeren Feld-Oxidschicht (sogenannte Feldplatte), auf der sich das Gate erstreckt, realisieren. Die Feld-Oxidschicht grenzt dabei an die drainseitige Kante der Gate-Oxidschicht an, überdeckt also die Oberfläche des Substrats im Dotierungsgebiet zwischen dem Drain-Anschlußgebiet und der Gate-Oxidschicht und reicht bis zum Drain-Anschlußgebiet. Durch diese Feldplatte wird das sich an der Oberfläche des Substrats ausbildende elektrische Feld weiter reduziert, was zur Verringerung der Gefahr von Durchbrüchen an der drainseitigen Gate-Kante beiträgt.

Wie sich aus dem Vorstehenden ergibt, ist der erfindungsgemäße MOS-Transistor mit einem in der oben beschriebenen Weise hergestellten weichen p-n-Übergang am Drain-Anschlußgebiet versehen. Dieser p-n-Übergang wird gebildet aus dem Dotierungsgebiet und dem Substrat. Sollte es bei dem erfindungsgemäßen MOS-Transistor zu einem Durchbruch infolge zu hoher Ausgangsspannung kommen, so ist es wünschenswert, daß der Durchbruch des p-n-Übergangs nicht an der Oberfläche in der Nähe des Gates stattfindet, sondern tief im Substrat, der p-n-Übergang also vertikal durchbricht. Dies wird mit Vorteil dadurch erreicht, daß man ein hochdotiertes Substrat mit einer schwachdotierten oberen (Epitaxie-) Schicht verwendet, in der die einzelnen Gebiete ausgebildet sind. Dadurch wird erreicht, daß die Raumladungszone des p-n-Übergangs unterhalb des Drain-Anschlußgebiets so weit eingeengt ist, daß ein Durchbruch in diesem Bereich eher stattfindet als im gatenahen Oberflächenbereich.

Nachfolgend wird anhand der Figuren ein Ausführungsbeispiel der Erfindung näher erläutert. Im einzelnen zeigen:
- Fig. 1: einen Querschnitt durch den oberflächennahen Bereich eines Substrats mit darin eingebrachten Dotierungsgebieten für einen NMOS-Transistor, wobei aus Gründen der Übersichtlichkeit die Kontaktierungen für Gate, Drain und Source nicht dargestellt sind,
- Fig. 2: den Verlauf der Oberflächen-Dotierungskonzentration entlang der Lateral-Erstreckung zwischen den Source- und Drain-Anschlußbereichen,
- Fig. 3: den Ionenimplantationsschritt zur Erzeugung des Dotierungsgebiets zwischen dem Drain und dem Gate und
- Fig. 4: die Situation nach dem Ausdiffundieren der gemäß Fig. 3 ionenimplantierten Teilgebiete.

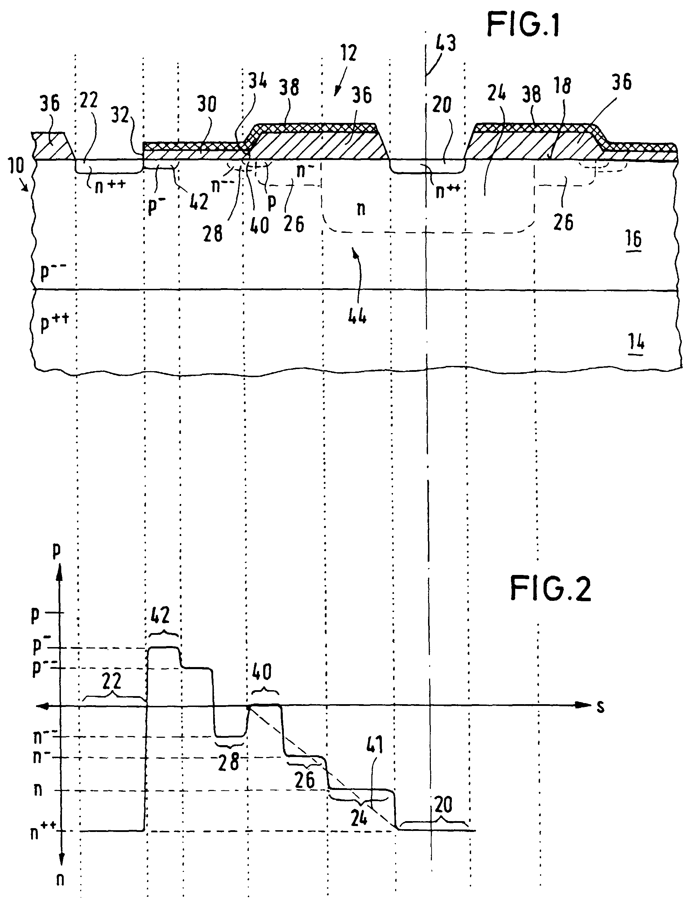

In Fig. 1 ist ein Querschnitt durch den oberflächennahen Bereich eines Halbleiter-Substrats 10 mit den für einen NMOS-Transistor 12 mit hoher Ausgangsspannungsfestigkeit erforderlichen unterschiedlich dotierten Gebieten gezeigt. Das Substrat 10 ist p-dotiert und weist eine untere Schicht 14 auf, die p-⁺⁺, also entartet dotiert ist (Dotierungskonzentration größer als 10¹⁸ elektrisch aktive Atome pro cm³). Auf die untere Schicht 14 aufgebracht ist eine obere (Epitaxie-) Schicht 16, die p⁻⁻-dotiert, also schwach p-dotiert ist und eine Dotierungskonzentration von 10¹⁴ bis 10¹⁵ elektrisch aktive Atome pro cm³) aufweist. Die Dicke der oberen Schicht 16 liegt zwischen 5 µm bis 6 µm. In die Oberfläche 18 der oberen Schicht 16 sind eine Vielzahl von unterschiedlich dotierten Gebieten ausgebildet, auf die im folgenden eingegangen wird.

Für den Anschluß von Drain und Source sind in die Oberfläche 18 des Substrats 10 entartet n⁺⁺-dotierte Anschlußgebiete 20 bzw. 22 eingebracnt. Während das Source-Anschlußgebiet 22 unmittelbar in das p⁻⁻-dotierte Material der oberen Schicht 16 eingebracht ist, befindet sich das Drain-Anschlußgebiet 20 in einem ersten Dotierungsteilgebiet 24, das schwächer n-dotiert ist als das Drain-Anschlußgebiet 20 (die Dotierungskonzentration im ersten Dotierungsteilgebiet 24 beträgt etwa 10¹⁷ elektrisch aktive Atome pro cm³). Die Tiefe des dotierten ersten Teilgebiets 24 liegt bei 3 µm bis 4 µm. Um das erste Teilgebiet 24 herum befindet sich ein zweites Teilgebiet 26, das n⁻-dotiert, also schwächer dotiert ist als das erste Teilgebiet 24. Die Dotierungskonzentration im zweiten Teilgebiet 26 liegt bei etwa 10¹⁶ elektrisch aktive Atome pro cm³). Das zweite Dotierungsgebiet 26 erstreckt sich als umlaufender Ring um das erste Teilgebiet 24. Außen um das zweite Teilgebiet 26 herum ist ein weiteres (zweites) Dotierungsteilgebiet 28 ausgebildet, das n⁺⁺-dotiert ist. Die Dotierungskonzentration dieses weiteren zweiten Teilgebiets 28 ist also niedriger als diejenige des ersten zweiten Teilgebiets 26 und beträgt etwa 10¹⁴ bis 10¹⁵ elektrisch aktive Atome pro cm³). Wie anhand der Fig. 1 durch gestrichelte Linien deutlich gemacht, ist die Tiefe des Teilgebiets 26 geringer als die Tiefe des ersten Teilgebiets 24; ferner ist die Tiefe des weiteren zweiten Teilgebiets 28 geringer als die Tiefe des ersten Teilgebiets 26. Mit anderen Worten nimmt die Tiefe der n-Dotierung ausgehend vom Drain-Anschlußgebiet 20 ab.

Die Teilgebiete 24,26 und 28 erstrecken sich wegen der Ringstruktur teilweise zwischen den beiden Anschlußgebieten 20 und 22 im oberflächennahen Bereich des Substrats 10. Das weitere zweite Teilgebiet 28 ist vom Source-Anschlußgebiet 22 beabstandet. In diesem Bereich ist auf die Oberfläche 18 der oberen Schicht 16 des Substrats 10 eine dünne Gate-Oxidschicht 30 aufgebracht. Die dem Source-Anschlußgebiet 22 zugewandte sourceseitige Kante 32 der Gate-Oxidschicht 30 fluchtet mit dem Source-Anschlußgebiet 22. Demgegenüber überlappt die dem Drain-Anschlußgebiet 20 zugewandte drainseitige Kante 34 der Gate-Oxidschicht 30 das weitere zweite Teilgebiet 28. Zwischen der Gate-Oxidschicht 30 und dem Drain-Anschlußgebiet 20 erstreckt sich eine dicke Feld-Oxidschicht 36. Beide Oxidschichten 30 und 36 sind von einem Polysilizium-Gate 38 überdeckt. Feld-Oxidschichten 36 befinden sich auch in dem Oberflächenbereich des NMOS-Transistors 12 auf dem Substrat.

In dem Übergangsbereich zwischen den beiden zweiten Teilgebieten 26 und 28 ist ein p-dotierter Bereich 40 eingebracht, der wie die Teilgebiete 24, 26 und 28 Ringstruktur aufweist. Dieser Ringbereich 40 ist derart stark p-gegendotiert, daß sich insgesamt im Bereich 40 eine Dotierstoffkonzentration von nahezu Null (intrinsisch, d.h. eine Dotierungskonzentration von kleiner als ungefähr 10¹² elektrisch aktive Atome pro cm³) einstellt. Die Anordnung des Bereichs 40 innerhalb der Oberfläche 18 des Substrats 10 ist derart getroffen, daß der Bereich 40 unterhalb der drainseitigen Kante 34 der Gate-Oxidschicht 30 verläuft.

Angrenzend an das Source-Anschlußgebiet 22 befindet sich unterhalb der Gate-Oxidschicht 30 in der Oberfläche 18 des Substrats 10 ein zur Einstellung der Schwellenspannung des NMOS-Transistors 12 vorgesehenes p⁻-dotiertes Gebiet 42. Dieses p⁻-Gebiet 42 ist ebenfalls als Ring ausgebildet und erstreckt sich nicht über die gesamte Länge zwischen dem Source-Anschlußgebiet 22 und dem zweiten Teilgebiet 28, sondern ist zum letzteren beabstandet.

Wie in den Figuren dargestellt, weist der NMOS-Transistor 12 einen bezüglich der Achse 43 symmetrischen Aufbau auf. Die Anschlußgebiete 20,24 sowie die Teilgebiete 24,26,28 und 42 sind konzentrisch zur Achse 43 ausgebildet. Selbiges gilt auch für die Oxidschichten 30 und 36 sowie die Polysiliziumschicht 38. Die somit als eine Art Guardring um Ring-Gate und Drain umlaufende Source schützt zum NMOS-Transistor benachbarte Schaltungsgebiete des Substrats 10.

In Lateral-Erstreckung zwischen den Anschlußgebieten 20 und 22 entlang der Oberfläche 18 des Substrats 10 stellt sich der in Fig. 2 dargestellte Dotierungskonzentrationsverlauf ein. Zu erkennen ist die intrinsische Dotierungskonzentration im Bereich 40 und der von da aus bis zum Drain-Anschlußgebiet stufenförmig ansteigende Dotierungskonzentrationsverlauf, der dem idealen geradlinigen Verlauf 41 (gestrichelt dargestellt) recht gut angenähert ist. Durch diesen langsamen Abbau der Dotierungskonzentration von dem Wert im Drain-Anschlußgebiet 20 bis auf den intrinsischen Wert an der drainseitigen Kante 34 der Gate-Oxidschicht 30 wird zwischen beiden ein ausreichend großer Bereich zur Ausbreitung der Raumladungszone im gesperrten Zustand des NMOS-Transistors 12 geschaffen. Im Vergleich zu herkömmlichen NMOS-Transistoren ist also die Raumladungszone zum Drain-Anschlußgebiet 20 hin verschoben. Damit erstreckt sie sich weniger weit unterhalb der Gate-Oxidschicht 30 in Richtung des Source-Anschlußgebiets 22. Damit kann der NMOS-Transistor 12 für eine kleinere Mindestkanallänge (Punch-Through-Effekt) ausgelegt werden. Die verbreiterte Raumladungszone trägt zum Abbau von Ausgangsspannungen zwischen dem Drain-Anschlußgebiet 20 und dem Polysilizium-Gate 38 bei, so daß ein prozentual geringerer Anteil über der Gate-Oxidschicht 30 an der drainseitigen Kante 34 abfallen muß. Damit besteht hier weniger die Gefahr eines Durchbruchs oder, anders ausgedrückt, der NMOS-Transistor 12 ist auch bei höheren Ausgangsspannungen noch durchbruchsicher. Zur Erhöhung der Durchbruchsicherheit trägt auch der intrinsische Bereich 40 unterhalb der drainseitigen Kante 34 der Gate-Oxidschicht 30 bei. Auch die als Feldplatte bezeichnete sich an die Gate-Oxidschicht 30 anschließende Feld-Oxidschicht 36 trägt zur Verringerung der Gefahr eines Durchbruches in der Gate-Oxidschicht 30 bei.

Nachfolgend soll auf die Herstellung des aus den drei Teilgebieten 24,26 und 28 zusammengesetzten Dotierungsgebiets 44 eingegangen werden. Das Besondere bei der Ausbildung dieses Dotierungsgebiets 44 besteht darin, daß die für MOS-Prozessoe üblichen Ionenimplantations- und Ausdiffusionsschritte verwendet werden.

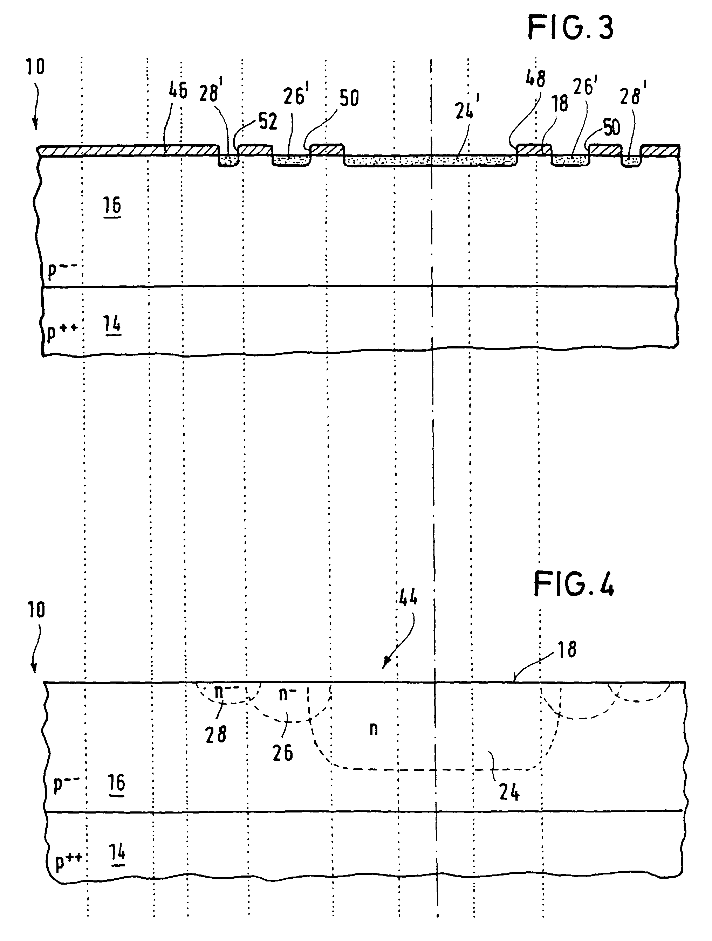

Wie man anhand der graphischen Darstellung des Implantationsschritts gemäß Fig. 3 erkennen kann, ist die Oberfläche 18 des Substrats 10 von einer Lackmaske 46 überzogen. Die Lackmaske 46 weist eine erste große Öffnung 48 zum Einbringen von Ionen für das spätere erste Dotierungsteilgebiet 24 auf. Um die Öffnung 48 herum ist eine Ringöffnung 50 in der Lackmaske 46 ausgebildet. Durch diese Ringöffnung 50 hindurch werden Ionen zur Herstellung des zweiten Dotierungsteilgebiets 26 in die Substratoberfläche implantiert. Der Abstand der Ringöffnung 50 zur Öffnung 48 und die laterale Erstreckung der Ringöffnung 50 sind dabei im Verhältnis zur Eindringtiefe der Ionen bei der späteren Ausdiffusion klein gewählt. Diese Einschränkung gilt nicht für die Öffnung 48, die eine wesentlich größere Abmessung als die Diffusionslänge aufweist. Um die Ringöffnung 50 herum ist mit Abstand zu dieser eine zweite Ringöffnung 52 in der Lackmaske 46 ausgebildet. Durch diese zweite Ringöffnung 52 werden in das Substrat die zur Ausbildung des (weiteren) zweiten Teilgebiets 28 erforderlichen Ionen eingebracht. Für den Abstand der Ringöffnung 52 zur Ringöffnung 50 sowie die Lateral-Erstreckung der Ringöffnung 52 gilt das oben im Zusammenhang mit der Ringöffnung 50 gesagte, wobei die Lateral-Erstreckung der Ringöffnung 52 kleiner gewählt ist als die Lateral-Erstreckung der Ringöffnung 50. In Fig. 3 sind mit 24',26' und 28' die ionenimplantierten Gebiete dargestellt, die sich durch den anschließenden Ausdiffusionsprozeß zu den dotierten Teilgebieten 24,26 und 28 ausbilden.

Wenn man einmal von einer Ausdiffusionslänge, d.h. von einer maximalen Eindringtiefe der implantierten Ionen im mittleren Bereich des ionenimplantierten Gebiets 24' von 3,5 µm ausgeht, so beträgt beispielsweise der Abstand der Ringöffnung 50 zur Öffnung 48 und der Abstand der Ringöffnung 52 zur Ringöffnung 50 jeweils 1,4 µm. Die Lateral-Erstreckung der Ringöffnung 50 liegt bei etwa 2 µm, während die Ringöffnung 52 eine Lateral-Erstreckung von etwa 1 µm aufweist.

Wie in Fig. 4 dargestellt, ergibt sich aufgrund der Ausmaskierung des Substrats 10 bei der Ionenimplantation gemäß Fig. 3 nach der thermischen Ausdiffusion das Dotierungsgebiet 44 mit den Dotierungsteilgebieten 24, 26 und 28, innerhalb derer die Eindringtiefe stufenweise unterschiedlich ist. Die Eindringtiefe innerhalb der zweiten Teilbereiche 26 und 28 ist deshalb geringer als innerhalb des ersten Teilbereichs 24, weil der prozentuale Anteil an Lateral-Diffusion in diesen zweiten Teilgebieten 26 und 28 wesentlich größer ist als die Vertikal-Diffusion, wenn beides verglichen wird mit den Gegebenheiten im ersten Teilgebiet 24. Infolge dieser unterschiedlichen Ausdiffusionen stellt sich an der Oberfläche 18 des Substrats 10 ein vom ersten Teilgebiet 24 über das zweite Teilgebiet 26 bis zum weiteren zweiten Teilgebiet 28 insgesamt abnehmender Dotierstoffkonzentrationsverlauf ein. Diese Aussage gilt auch für die oberflächennahen Bereiche des Substrats 10, innerhalb derer die Teilgebiete 24,26 und 28 ausgebildet sind.

Wie anhand der Fign. 3 und 4 zu erkennen ist, besteht der Vorteil der hier vorgestellten Modulation der Dotierstoffkonzentration im Bereich zwischen dem Drain-Anschlußbereich 20 und der Gate-Oxidschicht 30 darin, daß die technologisch kritischen Prozeßschritte "Implantation" und "Ausdiffusion" unverändert beibehalten werden können. Wird so, wie in den Fign. 3 und 4 dargestellt, zur Herstellung des Dotierungsgebiets 44 mit zum Gate hin abfallender Dotierungskonzentration gearbeitet, stellt sich notwendigerweise das in Fig. 4 und in Fig. 1 gezeigte Dotierungsprofil ein.

Wie anhand der Fign. 1 und 4 ferner zu erkennen ist, ist der Abstand zwischen der unteren Grenze des ersten Dotierungsteilgebiets 24 und der Trennung zwischen den beiden Schichten 14 und 16 des Substrats relativ gering. Bei einer Dicke der oberen Schicht 16 zwischen 5 µm und 6 µm und einer Ausdiffusionslänge von etwa 3,5 µm ergibt sich ein Abstand zwischen 1,5 µm und 2,5 µm. Wegen dieses geringen Abstandes und der Tatsache, daß unter Einhaltung dieses relativ kleinen Abstandes in vertikaler Richtung des Substrats 10 die hoch bis stark dotierte untere Schicht 14 folgt, wird die Raumladungszone zwischen dem ersten Teilgebiet 24 und dem Substrat 10 im unteren Bereich stark eingeschränkt. Damit kann man beeinflussen, daß ein Durchbruch des p-n-Übergangs eher in vertikaler Richtung als in lateraler Richtung an der drainseitigen Kante 34 der Gate-Oxidschicht 30 erfolgt. Bei einem vertikalen Durchbruch des p-n-Übergangs besteht eher die Möglichkeit, daß dieser reversibel ist, da in vertikaler Richtung mehr Substratmaterial vorhanden ist als in lateraler Richtung und dieses Substratmaterial demzufolge auch thermisch belastbarer ist als im Bereich der drainseitigen Kante 34 der Gate-Oxidschicht 30.

## Patentansprüche

1. MOS-Transistor mit hoher Ausgangsspannungsfestigkeit, mit
- einem Halbleiter-Substrat (10), das eine schwache Dotierung eines ersten Leitungstyps aufweist,
- zwei in die Oberfläche (18) des Substrats (10) eingebrachte voneinander beabstandete Anschlußgebiete (20,22) für Drain und Source, wobei die Anschlußgebiete (20,22) stark bis entartet dotiert und von einem dem ersten Leitungstyp entgegengesetzten zweiten Leitungstyp sind,
- einer auf die Oberfläche (18) zwischen den beiden Anschlußgebieten (20,22) für Drain und Source aufgebrachten Gate-Oxidschicht (30) mit einer an das Source-Anschlußgebiet (22) angrenzenden sourceseitigen Kante (32) und einer von dem Drain-Anschlußgebiet (20) beabstandeten drainseitigen Kante (34), und
- einem in die Oberfläche (18) des Substrats (10) von dem Drain-Anschlußgebiet (20) bis unterhalb der Gate-Oxidschicht (30) reichenden und von dem Source-Anschlußgebiet (22) beabstandeten Dotierungsgebiet (44) vom zweiten Leitungstyp, dessen Oberflächenkonzentration in dem an das Drain-Anschlußgebiet (20) angrenzenden Bereich höher ist als in dem Bereich unterhalb der Gate-Oxidschicht (30),
- wobei das Dotierungsgebiet (44) durch Ionenimplantation und anschließende Ausdiffusion eines an das Drain-Anschlußgebiet (20) angrenzenden ersten Teilgebiets (24), dessen Abmessung in Drain-Gate-Erstreckung wesentlich größer ist als die Eindringtiefe der Ausdiffusion in das Substrat (10), und mindestens eines zweiten Teilgebiets (26;28) gebildet ist, das zwischen dem ersten Teilgebiet (24) und dem Source-Anschlußgebiet (22) angeordnet ist und dessen Abmessung in Drain-Gate-Erstreckung sowie dessen Abstand zum ersten Teilgebiet (24) kleiner sind als die Eindringtiefe der Ausdiffusion in das Substrat (10), wobei die von den einzelnen jeweils benachbarten ersten und zweiten Teilgebieten (24,26;24,28) ausgehen den Einzeldiffusionen zur Erzielung eines Dotierungskonzentrationsgradienten bei gleichbleibendem Leitungstyp des Dotierungsgebiets an der Oberfläche (18) des Substrats (10) ineinanderlaufen,
- wobei - in Draufsicht auf die Oberfläche (18) des Substrats (10) betrachtet - das erste Teilgebiet (24) sich um das Drain-Anschlußgebiet (20) herum erstreckt,
dadurch gekennzeichnet,
- daß das mindestens eine zweite Teilgebiet (26;28) als sich um das erste Teilgebiet (24) erstreckender Ring ausgebildet ist, und
- daß innerhalb des Dotierungsgebiets (44) unterhalb der drainseitigen Kante (34) der Gate-Oxidschicht (30) in der Oberfläche (18) des Substrats (10) eine Intrinsic-Zone (40) angeordnet ist, die durch Ausbilden eines dotierten Bereichs vom ersten Leitungstyp hergestellt ist.

2. MOS-Transistor nach Anspruch 1, dadurch gekennzeichnet, daß mehrere nebeneinanderliegende zweite Teilgebiete (26,28) vorgesehen sind, deren Abmessungen in Drain-Gate-Erstreckung und deren Abstände untereinander bzw. zum ersten Teilgebiet (24) jeweils kleiner sind als die Eindringtiefe der Ausdiffusion in das Substrat (10), wobei mit zunehmender Entfernung der zweiten Teilgebiete (26,28) vom ersten Teilgebiet (24) sich die Abmessungen der zweiten Teilgebiete (26,28) in Drain-Gate-Erstreckung verkleinern.

3. MOS-Transistor nach Anspruch 2, dadurch gekennzeichnet, daß die Abstände benachbarter zweiter Teilgebiete (26,28) jeweils im wesentlichen gleich sind.

4. MOS-Transistor nach Anspruch 1 oder 2, dadurch gekennzeichnet, daß mehrere nebeneinanderliegende zweite Teilgebiete (26,28) vorgesehen sind, deren Abmessungen in Drain-Gate-Erstreckung und deren Abstände untereinander bzw. zum ersten Teilgebiet (24) jeweils kleiner sind als die Eindringtiefe der Ausdiffusion in das Substrat (10), wobei mit zunehmender Entfernung der zweiten Teilgebiete (26,28) vom ersten Teilgebiet (24) sich der Abstand jeweils benachbarter zweiter Teilgebiete (26,28) vergrößert.

5. MOS-Transistor nach einem der Ansprüche 1 bis 4, dadurch gekennzeichnet, daß unterhalb der Gate-Oxidschicht (30), angrenzend an das Source-Anschlußgebiet (22) und beabstandet von dem nächstliegenden ausdiffundierten zweiten Teilgebiet (26;28), ein zum Einstellen der Schwellenspannung dotiertes Gebiet (42) vom ersten Leitungstyp angeordnet ist.

6. MOS-Transistor nach einem der Ansprüche 1 bis 5, dadurch gekennzeichnet, daß sich an die drainseitige Kante (34) der Gate-Oxidschicht (30) eine Feld-Oxidschicht (36) anschließt, die dicker ist als die Gate-Oxidschicht (30).

7. MOS-Transistor nach einem der Ansprüche 1 bis 6, dadurch gekennzeichnet, daß das Substrat (10) eine die Oberfläche (18) umfassende obere Schicht (16) und eine diese tragende untere Schicht (14) aufweist und daß die obere Schicht (16) wesentlich niedriger dotiert ist als die untere Schicht (14).

8. MOS-Transistor nach einem der Ansprüche 1 bis 7, dadurch gekennzeichnet, daß das vom Drain-Anschlußgebiet (20) am weitesten entfernte Teilgebiet (28) aus nebeneinanderliegenden insbesondere punktförmigen Gebieten besteht.

9. MOS-Transistor nach einem der Ansprüche 1 bis 8, mit einem Aufbau, der zu einer senkrecht zur Oberfläche (18) des Substrats (10) und durch das Drain-Anschlußgebiet (20) hindurch verlaufenden Achse (43) konzentrisch bzw. symmetrisch ist.

## Claims

1. An MOS transistor with high output voltage endurance, comprising
- a semiconductor substrate (10) provided with a weak doping of a first conduction type,
- two mutually spaced conduction areas (20,22) for drain and source formed in the surface (18) of the substrate (10), the conduction areas (20,22) being provided with a heavy up to excessive doping and being of a second conduction type opposite to the first conduction type,
- a gate oxide layer (30) applied on the surface (18) between the two conduction areas (20,22) for drain and source, having a source-side edge (32) adjacent the source connection area (22) and a drain-side edge (34) spaced from the drain connection area (20), and
- a doping area (44) of the second conduction type extending into the surface (18) of the substrate (10) from the drain connection area (20) to below the gate oxide layer (30) and spaced from the source connection area (22), the surface concentration of the doping area (44) in the area adjacent the drain connection area (20) being higher than in the region below the gate oxide layer (30),
- the doping area (44) being formed by ion implantation and subsequent outdiffusion of a first partial area (24) adjacent the drain connection area (20), the size of the first partial area (24) in the drain-gate extension being considerably larger than in the penetrating depth of the outdiffusion into the substrate (10), and of at least one second partial area (26;28) arranged between the first partial area (24) and the source connection area (22), the size of the at least one second partial area (26;28) in the drain-gate extension and the distance thereof to the first partial area (24) being smaller than the penetrating depth of the outdiffusion into the substrate (10), wherein, while maintaining the same conduction type of the doping area, the individual diffusions originating from the individual, respectively adjacent first and second partial areas (24,26;24,28) merge into each other on the surface (18) of the substrate (10) to thus obtain a doping concentration gradient,
- wherein - when seen in plan view onto the surface (18) of the substrate (10) - the first partial area (24) extends around the drain connection area (20),
characterized in
- that the at least one second partial area (26; 28) is formed as a ring extending around the first partial area (24), and
- an intrinsic zone (40) is arranged in the surface (18) of the substrate (10) within the doping area (44) below the drain-side edge (34) of the gate oxide layer (30), said intrinsic zone (40) being generated by forming a doped area of the first conduction type.

2. The MOS transistor according to claim 1, characterized in that a plurality of adjacent second partial areas (26,28) are provided, their sizes in the drain-gate extension and their distances to each other and to the first partial area (24), respectively, being smaller than the penetration depth of the outdiffusion into the substrate (10), with the sizes of the second partial areas (26,28) in the drain-gate extension decreasing with increasing distance of the second partial areas (26,28) from the first partial area (24).

3. The MOS transistor according to claim 2, characterized in that the distances between adjacent second partial areas (26,28) are respectively substantially identical.

4. The MOS transistor according to claim 1 or 2, characterized in that a plurality of adjacent second partial areas (26,28) are provided, their sizes in the drain-gate extension and their distances to each other and to the first partial area (24), respectively, being smaller than the penetration depth of the outdiffusion into the substrate (10), with the distance between respectively adjacent second partial areas (26,28) increasing with increasing distance of the second partial areas (26,28) from the first partial area (24).

5. The MOS transistor according to any one of claims 1 to 4, characterized in that an area (42) of the first conduction type doped for setting the threshold voltage, is arranged below the gate oxide layer (30), adjacent the source connection area (22) and spaced from the nearest outdiffused second partial area (26;28).

6. The MOS transistor according to any one of claims 1 to 5, characterized in that the drain-side edge (34) of the gate oxide layer (30) is joined by a field oxide layer (36) thicker than the gate oxide layer (30).

7. The MOS transistor according to any one of claims 1 to 6, characterized in that the substrate (10) comprises an upper layer (16) including the surface (18), and a lower layer (14) supporting the upper layer (16), and that the upper layer (16) is considerably less doped than the lower layer (14).

8. The MOS transistor according to any one of claims 1 to 7, characterized in that the partial area (28) arranged at the largest distance from the drain connection area (20) consists of adjacent and particularly dot-like areas.

9. The MOS transistor according to any one of claims 1 to 8, having a configuration concentric with or symmetrical to an axis (43) extending vertically to the surface (18) of the substrate (10) and through the drain connection area (20).

## Revendications

1. Transistor MOS à haute rigidité diélectrique de sortie comprenant:
- un substrat semi-conducteur (10) qui présente un dopage faible d'un premier type de conduction,
- deux zones de connexion (20, 22) de drain et de source espacées l'une de l'autre introduites dans la surface (18) du substrat, les zones de connexion (20, 22) étant dopées fortement jusqu'à dégénérescence et étant d'un deuxième type de conduction opposé au premier type de conduction;
- une couche d'oxyde de grille (30) appliquée sur la surface (18) entre les deux zones de connexion (20, 22) de drain et de source, et pourvue d'une arête (32) côté source adjacente à la zone de connexion(22) de source et d'une arête côté drain (34) espacée de la zone de connexion(20) de drain, et
- une zone de dopage (44) du deuxième type de conduction qui s'étend dans la surface (18) du substrat (10) à partir de la zone de connexion (20) de drain jusqu'au-dessous de la couche de grille (30) et est espacée de la zone de connexion (22) de source et dont la concentration superficielle dans la région adjacente à la zone de connexion (20) de drain est supérieure à celle de la région sous-jacente à la couche d'oxyde de grille (30),
- la zone de dopage (44) étant formée par implantation ionique suivie par une diffusion vers l'extérieur d'une première zone partielle (24) adjacente à la zone de connexion (20) de drain, dont la dimension en étendue drain-grille est sensiblement supérieure à la profondeur de pénétration de la diffusion vers l'extérieur dans le substrat (10), et d'au moins une deuxième zone partielle (26; 28) qui est agencée entre la première zone partielle (24) et la zone de connexion (22) de source et dont la dimension dans l'étendue drain-grille ainsi que sa distance à la première zone partielle (24) sont inférieures à la profondeur de pénétration de la diffusion vers l'extérieur dans le substrat (10), les diffusions individuelles qui partent de la première et de la deuxième zones partielles (24, 26; 24, 28) individuelles respectivement voisines se réunissant pour atteindre un gradient de concentration de dopage pour un type inaltéré de conduction de la zone de dopage à la surface (18) du substrat (10),
- la première zone partielle (24) s'étendant autour de la zone de connexion (20) du drain, en vue de dessus de la surface (18) du substrat (10),
caractérisé en ce que
- au moins une deuxième zone partielle (26; 28) est réalisée sous forme d'anneau s'étendant autour de la première zone partielle (24), et en ce que
- une zone intrinsèque (40) qui est fabriquée en formant une région dopée du premier type de conduction est agencée à l'intérieur de la zone de dopage (44) au-dessous de l'arête (34) de la couche d'oxyde de grille située sur le côté drain (30) dans la surface (18) du substrat (10).

2. Transistor MOS selon la revendication 1, caractérisé en ce qu'il inclut plusieurs deuxièmes zones partielles adjacentes (26, 28) dont les dimensions selon l'étendue drain-grille et les distances entre elles et la première zone partielle (24) sont respectivement inférieures à la profondeur de pénétration de la diffusion vers l'extérieur dans le substrat (10), les dimensions des deuxièmes zones partielles (26, 28) décroissant en étendue drain-grille lorsque l'éloignement entre les deuxièmes zones partielles (26, 28) et la première zone partielle (24) croît.

3. Transistor MOS selon la revendication 2, caractérisé en ce que les distances entre deux zones partielles voisines (26, 28) sont sensiblement égales.

4. Transistor MOS selon la revendication 1 ou revendication 2, caractérisé en ce qu'il inclut
caractérisé en ce qu'il inclut plusieurs deuxièmes zones partielles adjacentes (26, 28) dont les dimensions selon l'étendue drain-grille et les distances entre elles et la première zone partielle (24) sont respectivement inférieures à la profondeur de pénétration de la diffusion vers l'extérieur dans le substrat (10), la distance respective entre des deuxièmes zones partielles voisines (26, 28) croissant lorsque l'éloignement entre les deuxièmes zones partielles (26, 28) et la première zone partielle (24) croît.

5. Transistor MOS selon l'une quelconque des revendications 1 à 4, caractérisé en ce qu'une zone dopée (42) du premier type de conduction est agencé pour le réglage de la tension de seuil au-dessous de la couche d'oxyde de grille (30), adjacente à la zone de connexion (22) de source et éloignée de la deuxième zone partielle la plus voisine (26; 28) formée par diffusion vers l'extérieur.

6. Transistor MOS selon l'une quelconque des revendications 1 à 5, caractérisé en ce qu'une couche (36) d'oxyde de champ qui est plus épaisse que la couche d'oxyde de grille (30) se raccorde à l'arête (34) de la couche d'oxyde de grille située sur le côté drain (30).

7. Transistor MOS selon l'une quelconque des revendications 1 à 6, caractérisé en ce que le substrat (10) comporte une couche supérieure (16) entourant la surface (18) et une couche inférieure (14) qui porte la précédente et en ce que la couche supérieure (16) est dopée de façon sensiblement moindre que la couche inférieure (14).

8. Transistor MOS selon l'une quelconque des revendications 1 à 7, caractérisé en ce que la zone partielle (28) qui est la plus éloignée de la zone de connexion (20) de drain se compose de zones adjacentes en particulier ponctuelles.

9. Transistor MOS selon l'une quelconque des revendications 1 à 8, qui comporte un axe (43) concentrique ou axe de symétrie perpendiculaire à la surface (18) du substrat (10) et traversant la zone de connexion (20) de drain.
